# EUROPÄISCHE PATENTANMELDUNG

(11) **EP 0 966 187 A2**
(43) Veröffentlichungstag der Anmeldung: **22.12.1999**
(21) Anmeldenummer: 99111467.9
(22) Anmeldetag: 12.06.1999
(51) Int. Cl.: H05K 3/46, H05K 1/02, H05K 1/11

(54) **Multilayer-Schaltungsaufbau mit beidseitiger SMD-Bestückung**

(30) Priorität: 18.06.1998 DE 19827089
(71) Anmelder: Diehl Stiftung & Co., 90478 Nürnberg (DE)
(72) Erfinder: Graf, Hans-Rainer, 96049 Bamberg (DE)
(74) Vertreter: Hofmann, Gerhard, Dipl.-Ing. Patentassessor

(57) **Zusammenfassung**

Ein insbesondere beidseitig mit SMD-Bauelementen 23 zu bestückender Multilayer-Schaltungsaufbau 11 weist jeweils zwischen seiner die Montageoberfläche 22 bildenden äußeren Leit-Folie 21 und dem Stapel 14 aus kaschierten Leiterplatten 17 eine gelochte Metallschichtplatte als Entkopplungslage 20 zur Kompensation der unterschiedlichen thermischen Ausdehnungskoeffizienten der Bauelemente 23 gegenüber dem Platinenstapel 14 auf. Die elektrische Verbindung zwischen der Montageoberfläche 22 und den untereinander sowie mit einer Verdrahtungs-Decklage 21' mittels Durchstiegen 24 verschalteten Ebenen der Leiterplatten-Kaschierungen 17 erfolgt über Sacklöcher 12 von der Montageoberfläche 22 her, die unter axialem Versatz gegenüber den Achsen 33 der schaltungstechnisch zugeordneten Durchstiege 24 mit ihren galvanisierten Mantelflächen (30) in die Leiterplatten-Kaschierungen 17 eingesenkt sind, welche dadurch biegeweich verzahnte, stufenförmig verlaufende Übergänge 17s zwischen den beiderseitigen Anschluß-Bohrlöchern 27 bilden. Dadurch ist eine S-förmig verlaufende, elastische und deshalb von den achsparallel wirkenden thermischen Beanspruchungen nicht mehr aufbrechbare elektromechanische Verbindung zwischen den Sacklöchern 12 und ihren Durchstiegen 24 geschaffen.

## Beschreibung

Die Erfindung betrifft einen Multilayer-Schaltungsaufbau gemäß dem Oberbegriff des Anspruches 1, wie er z.B. aus der EP 0789390 A2, aus der EP 0220508 A2 oder (mit Schwerpunkt bei den Anschlußtechniken) aus der DE 3923533 A1 für die Realisierung höchst komplexer Schaltungen auf engstem Raum etwa in Hybridtechnik bekannt ist

Der Erfindung liegt die Aufgabe zugrunde, einen besonders funktionstüchtigen derartigen Schaltungsaufbau auch für den Fall zu schaffen, daß eine sehr große Anzahl von Leiterplatten übereinander gestapelt und der Stapel insgesamt beidseitig für die SMD-Bestückung vorgesehen ist.

Als besonderes Problem bei sehr dicken Leiterplattenstapeln mit beidseitiger SMD-Bestückung hat sich nämlich herausgestellt, daß die in relativ dichter gegenseitiger Nachbarschaft flach auf die Montageoberfläche aufgebrachten Bauelemente unter Dauerbetrieb in erheblichem Maße Wärme auch in das Innere des Leiterplatten-Stapels einkoppeln und dort zu kritischen Wärme-Ausdehnungen der unterschiedlichen Materialien führen. Diese Gefährdung für die mechanische Beständigkeit und elektrische Funktion des Schaltungsaufbaues läßt sich zwar beherrschen, wenn eine Anpassung der verschiedenen thermischen Ausdehnungskoeffizienten zwischen der äußersten Leiterplatte und der eigentlichen Montageoberfläche für die Bauelemente eingebaut wird; die dann je nach Anforderung auf beiden Seiten des Stapels vorgesehen werden kann, um Verwerfungen aufgrund von Bimetall-Effekten zu vermeiden. Ein solcher Aufbau bedingt aber zusätzliche Sacklöcher, die nachträglich, nämlich nach der internen Verschaltung und dem Zusammenfügen des Leiterplattenstapels, von der Montageoberfläche her bis unter die Ebene der Entkopplungslage eingebohrt werden. Über eine elektrisch leitende Galvanisierung der Sacklochwandungen wird dann die Montageoberfläche an die Leiterplatten-Verschaltungen angeschlossen, die im Innern des Stapels über Durchstiege (sog. Vias in Form von ebenfalls elektrisch galvanisierten Bohrlöchern) zwischen den Ebenen der Leiterplatten-Kaschierungen zuvor schon realisiert wurden. Die dafür einzusetzende Bohrtechnik ist etwa in dem Fachartikel 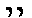 Warum sind Sacklöcher wichtig" von P. Kersten, Zeitschrift 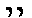 productronic" Heft 9/97, näher beschrieben. Um einen Kurzschluß nebeneinanderliegender der innen galvanisierten Sacklöcher über die davon gekreuzte metallische Entkopplungslage zu vermeiden, wird diese schon vor ihrem Einbau an denjenigen Koordinaten mit hinreichend großen Durchgangsöffnungen ausgestattet, an denen später die Sacklöcher dagegen kleineren Durchmessers in den Leiterplatten-Stapel gebohrt werden.

Für diesen elektromechanischen Anschluß der durch Galvanisierung elektrisch leitend gemachten Sacklöcher an schaltungstechnisch zugeordnete Leiterplatten-Durchstiege wäre es an sich aus Gründen der Platzoptimierung und der Fertigungslogistik zweckmäßig, gleiche Flächenkoordinaten für beide Bohrungen (Durchstiege und Sacklöcher) vorzugeben, also die Sacklöcher koaxial zu zugeordneten Durchstiegen zu bohren und dabei beide stirnseitig auf Stoß miteinander zu kontaktieren. Es hat sich jedoch überraschend gezeigt, daß eine solche an sich ohne weiteres naheliegende Kontaktierung von unzuverlässiger Qualität ist, weil sich während des Dauerbetriebes im Kontaktierungsbereich Übergangs-Unterbrechungen ausbilden können, welche den elektrischen Übergangswiderstand unreproduzierbar vergrößern und u.U. schließlich sogar ganz abbrechen lassen. Das kommt daher, daß die unter den SMD-Bauelementen angeordnete Entkopplungslage die Thermalausdehnungen nur in X- und in Y-Richtung (also in der Plattenebene) aufnimmt, aber nicht auch in Z-Richtung (also nicht auch in der Dicken-Richtung, quer zur Plattenebene selbst) - wodurch die gesamte Kraftwirkung der Thermalausdehnungen auf den koaxialen Übergang vom Sackloch zum Durchstieg einwirkt. Dort wirkt sich dann sehr stark aus, daß der quer zur Flächenerstreckung wirksame thermische Ausdehnungskoeffizient des Kunststoffmaterials der Leiterplatten, bei dem es sich etwa um ein Laminat aus Polyimid-Glaserfasergeflechten als Träger für die leitenden Kaschierungen handelt, wesentlich größer ist als der axiale Ausdehungskoeffizient der quer zur Ebene der Leiterplatten orientierten metallisierten Sacklöcher und Durchstiege. Daraus resultiert unter Wärmebeanspruchung eine von den gestapelten Leiterplatten-Laminaten ausgehende Zugbeanspruchung der stirnseitig zusammenstoßenden Querverbindungen (also der stirnseitigen Kontaktgaben zwischen den Sackbohrungen und den Durchstiegen); und die über die Betriebszyklen schwankende Dehnbeanspruchung im Kontaktbereich führt dort schließlich zum Bruch der Verbindung eines Sackloches mit dem sich anschließenden Durchstieg an der Verbindungs-Grenzfläche.
Diese unter extremen Gegebenheiten (beidseitig SMD-bestückter dicker Leiterplatten-Stapel mit Betrieb unter sehr starken Temperaturschwankungen) die Betriebszuverlässigkeit solcher Schaltungsanordnungen beeinträchtigenden Erscheinungen werden gemäß vorliegender Erfindung nun dadurch beherrscht, daß aufbauend auf die geschilderten Erkenntnisse künftig die Bohrkoordinaten derart gewählt werden, daß die Sacklöcher axial gegenüber den Durchstiegen versetzt von den Montageoberflächen her eingebracht werden; und zwar jeweils so tief gebohrt, daß sie eine an sie elektrisch angeschlossene Leiterplatten-Kaschierung durchdringen, die radial dagegen versetzt auch vom elektrisch zugeordneten Durchstieg durchdrungen wird. Die galvanisierten Bohrungs-Ränder verbinden sich jeweils mit der ringförmig an sie anstoßenden Kaschierung, und das kurze Kaschierungs-Verbindungsstück zwischen den beiden Bohrungen (Sackloch und daran anzuschließendem Durchstieg) wirkt gewissermaßen als biegeelastische elektrisch leitende Verbindungsbrücke. Dieser stufen-förmige elektromechanische Übergang stellt somit eine mechanisch axial versetzbare Struktur mit einem Federeffekt dar, der thermisch bedingte Materialverlagerungen ausgleicht, so daß es nicht mehr zu den kritischen Abrißerscheinungen an den Grenzflächen wie beim koaxial stumpfen Zusammenfügen zweier Leiter in Richtung der thermisch bedingten Zugbeanspruchung in Richtung der Z-Achse durch den Leiterplatten-Stapel kommt.

Zusätzliche Alternativen und Weiterbildungen sowie weitere Merkmale und Vorteile der Erfindung ergeben sich aus den weiteren Ansprüchen und aus nachstehender Beschreibung eines in der Zeichnung unter Beschränkung auf das Wesentliche und nicht ganz maßstabsgerecht skizzierten bevorzugten Realisierungsbeispieles zur erfindungsgemäßen Lösung. In der Zeichnung zeigt:
- Fig. 1: einen Multilayer-Schaltungsaufbau in abgebrochener Querschnittsdarstellung mit dem erfindungsgemäß ausgelegten Übergang von einem Sackloch über eine Leiterplatten-Kaschierung zu einem Durchstieg; und zum Vergleich damit
- Fig. 2a/b: der Erfindung zuwiderlaufende unmittelbare Anschlüsse zwischen metallisierten Sacklöchern einerseits und andererseits Leiterplatten-Kaschierungen bzw. elektrisch leitenden Durchstiegen.

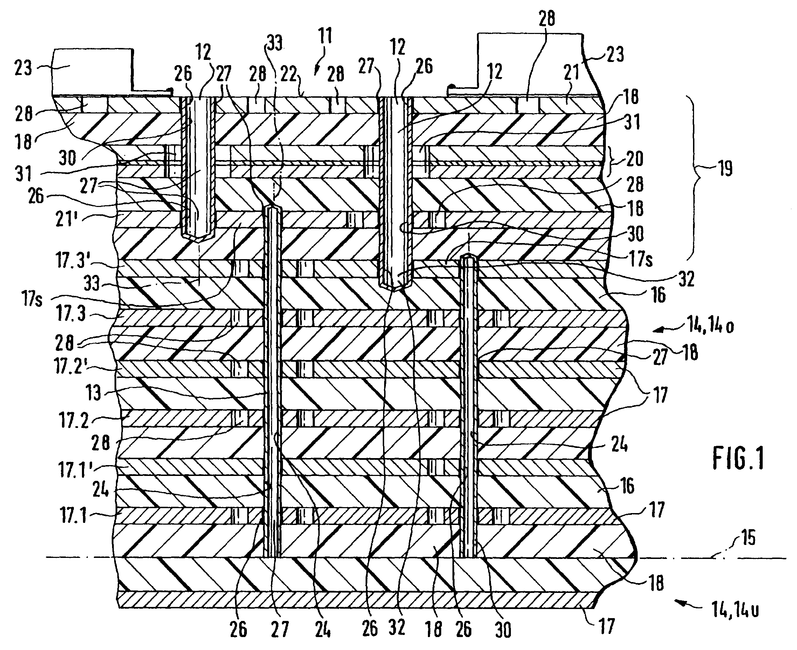

Der in Fig. 1 skizzierte Längsschnitt durch einen Mulilayer-Schaltungsaufbau 11 ist so gelegt, daß er gerade durch die Achse zweier Sacklöcher 12 und je eines an diese elektrisch angeschlossenen Durchstieges 13 verläuft.

Der Schaltungsaufbau 12 besteht aus zwei gleich gruppierten aber über Klebeschichten 18-18 gegensinnig aneinandergefügten Stapeln 14, nämlich einem oberen Stapel 14o und einem damit verbundenen unteren Stapel 14u beiderseits einer Mittenebene 15 durch den Schaltungsaufbau 11. In jedem Stapel 14 liegen mehrere, zur Ausbildung von Leiterbahnenstrukturen beidseitig z.B. mit Kupferfolien (Kaschierungen 17; 17.1 .... 17.3') belegte, hier sogenannte Leiterplatten 16 übereinander (in der Skizze nur drei Lagen 1 .. 3), bei denen es sich für Multilayer-MCMs um kupferkaschierte Folien aus Basismaterial handelt. Vorzugsweise enthalten sie jeweils ein mechanisch und thermisch stabiles sowie einen guten elektrischen Isolator darstellendes Laminat von Polyimid-Glasfasergeweben. Die einzelnen kaschierten Leiterplatten 16 sind, nachdem (in als solcher aus der Technologie der gedruckten Schaltungen bekannter Art) aus ihren Kaschierungen 17 Schaltungsstrukturen freigeätzt sind, mittels gut isolierender und haftender Harz-Klebeschichten 18 flächig miteinander verbunden und verpreßt. Zum äußeren Abschluß ist jeder Stapel 14u, 14o aus eingangs dargelegten Gründen über eine weitere Klebeschicht 18 mit einem Temperaturschutzaufbau 19 belegt. Der beinhaltet im wesentlichen eine thermische Entkopplungslage 20, die vorzugsweise als großvolumige, also großflächige und dicke Wärniesenke etwa in Form einer Kupfer-Invar-Kupfer-Metallschichtplatte ausgelegt ist, welche ihrerseits zur Vermeidung von thermischen Bimetall-Effekten beiderseits über Klebeschichten 18 mit leitenden Folien 21, 21' etwa aus Kupfer belegt ist.

Jeweils die Außenfläche der im Stapel 14 außen gelegenen Folie 21 dient als die Montageoberfläche 22 für oberflächenmontierte diskrete oder integrierte elektrische Bauelemente (SMDs) 23. Die ihr jenseits der Entkopplungslage 20 gegenüberliegende Folie kann, wie in der Zeichnung berücksichtigt, zugleich die Funktion einer Verdrahtungs-Decklage 21' für den dahinter bis zur Mittenebene 15 sich anschließenden Leiterplatten-Stapel 14o ausüben.

Schon vor der Verbindung der beiden Stapel 14o/14u zum Gesamt-Schaltungsaufbau 11 werden nach Maßgabe der vorgegebenen elektrischen Funktionen bestimmte übereinanderliegende Bereiche bestimmter Ebenen von Leiterbahnkaschierungen 17 gleicher oder unterschiedlicher Leiterplatten 16 mittels Durchstiegen 24, sogenannten Vias, elektrisch miteinander verbunden. Diese werden (vorzugsweise vor dem Zusammenkleben der beiden Stapel 14o/14u von der Mittenebene 15 her) an den dafür vorgegebenen Positionen quer zu den Stapel-Ebenen eingebohrt, und die Bohrungen werden dann längs ihrer Mantelflächen mit einer aufgalvanisierten Metallisierung 25 versehen, was eine mechanisch und elektrisch zuverlässige leitenden Verbindung zu den Rändern 26 der Bohrlöcher 27 durch die Leiterplattenkaschierungen 17 hindurch erbringt. Bedarfsweise sind um diese dabei entstehenden Bohrlöcher 27 herum zuvor schon beim Ätzen der Schaltungsstrukturen z.B. ringförmige Unterbrechungen 28 in die Leiterplattenkaschierungen 17 eingebracht, um eine elektrische Verbindung zwischen dem jeweiligen Durchstieg 24 und der weiterführenden Leiterplatten-Kaschierung 17 in dieser Ebene zu vermeiden; während an den anderen Bohrloch-Positionen die Leiterplatten-Kaschierung 17 als Potentialverbindung oder Strompfad un-unterbrochen bis zum nächsten Durchstieg 24 heranreicht.

Für die elektrische Verbindung von der Träger-Folie 21 zur Aufnahme der außenliegenden Bauelemente 23 zum Innern des Schaltungsaufbaues 11 sind von deren Montage-Oberfläche 22 achsparallel zu den Durchstiegen 24 Sacklöcher 29 in den jeweiligen Stapel 14 eingebohrt, die einen signifikant größeren Durchmesser als die Durchstiege 24 aufweisen und ebenfalls eine elektrisch gut leitende Mantelflächen-Galvanisierung 30 erhalten. Auch die verbindet sich mechanisch und elektrisch leitend mit dem jeweiligen Bohrloch-Rand 26 in den Kaschierungen 17 bzw. Folien 21, 21'; weshalb die Bohrlöcher 27 wieder von Unterbrechungen 28 umgeben sind, wo kein elektrisch leitender Anschluß zu weiter abgelegenen Bereichen einer Leiterplatten-Kaschierung 17 vorgesehen ist.

Die Lage der Sackloch-Bohrlöcher 27 in der äußeren Folie 21 ist aus Gründen der Funktionssicherheit und der Möglichkeit zur Qualitätsprüfung gegenüber der Position der mittels Lot oder dergleichen Leitkleber auf die Oberfläche 22 montierten Bauelemente 23 versetzt. Damit die metallene Entkopplungslage 20 keinen Kurzschluß zwischen den galvanisierten Sacklöchern 12 hervorruft, ist sie an den entsprechenden Bohrkoordinaten bereits vor ihrer Montage mit Durchgangsöffnungen 31 entsprechend größeren Durchmessers versehen worden.

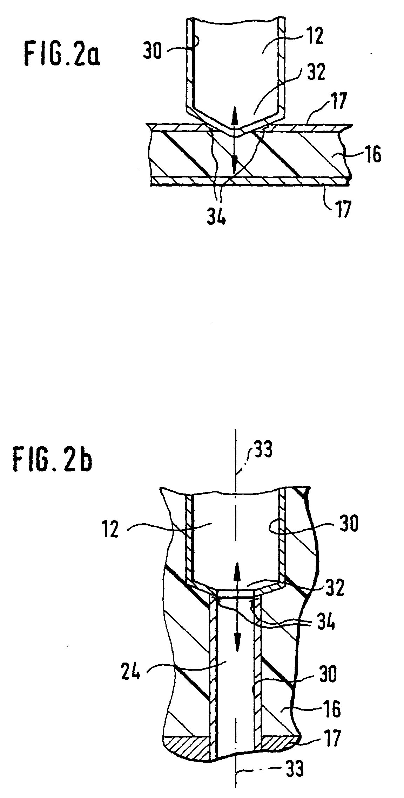

Es könnte als naheliegend angesehen werden, die stumpfwinkelig-hohlkegelförmigen, innen metallisierten Enden der Sacklöcher 12 gemäß Fig. 2a unmittelbar in einer Leiterplatten-Kaschierung 17 auf einer Leiterplatte 16 enden zu lassen; oder sogar koaxial vor der Stirn eines schaltungsmäßig zugeordneten Durchstieges 24 gemäß Fig.2b. Aber dann besteht die eingangs geschilderte Gefahr, daß sich im Anschluß-Grenzbereich infolge thermisch-mechanischer Beanspruchung Risse 34 ausbilden, die den sicheren elektrischen Kontakt durch Unterbrechung oder jedenfalls durch wachsenden elektrischen Übergangswiderstand gefährden. Deshalb ist gemäß vorliegender Erfindung (Fig. 1) ein S- oder stufen-förmiger, im Querschnitt möglichst rechtwinklig verlaufender Übergang jeweils zwischen den leitenden Zylindermantelflächen eines Sackloches 12 und dem an ihn elektrisch anzuschließenden Durchstieg 24 über einen radial an die jeweilige Mantelfläche sich anschließenden Übergang 17s der durchbohrten Leiterplatten-Kaschierung 17 vorgesehen. Die zwischen dem Bohrungs-Rand 26 in der Kaschierung 17s und der angrenzenden Galvanisierung 30 bzw. 25 auftretende Verzahnung beiderseits des Überganges 17s stellt einen mechanisch und elektrisch zuverlässigen da als abgewinkelt verlaufende Biegefeder wirkenden Anschluß dar, der thermisch nicht mehr gefährdet ist, weil seine Verformungsmöglichkeit die in Z- oder Dickenrichtung des Plattenstapels 14 auftretenden mechanischen Spannungen aufnimmt.

Ein beidseitig mit SMD-Bauelementen 23 zu bestückender Mulilayer-Schaltungsaufbau 11 weist also jeweils zwischen seiner die Montageoberfläche 22 bildenden äußeren Leit-Folie 21 und dem Stapel 14 aus kaschierten Leiterplatten 17 eine gelochte Metallschichtplatte als Entkopplungslage 20 zur Kompensation der sehr unterschiedlichen thermischen Ausdehnungskoeffizienten der Bauteile 23 und des Platinen-Stapels 14 auf Die elektrische Verbindung zwischen der Montageoberfläche 22 und den untereinander sowie mit einer Verdrahtungs-Decklage 21' mittels Durchstiegen 24 verschalteten Ebenen der Leiterplatten-Kaschierungen 17 erfolgt über Sacklöcher 12 von der Montageoberfläche 22 her, die erfindungsgemäß unter axialem Versatz gegenüber den Achsen 33 der schaltungstechnisch zugeordneten Durchstiege 24 mit ihren galvanisierten Mantelflächen (30, 25) in die Leiterplatten-Kaschierungen 17 eingesenkt sind, welche so biegeweich verzahnte und geschwungen verlaufende Übergänge 17s zwischen den beiderseitigen Anschluß-Bohrlöchern 27 bilden. Dadurch ist eine stufen- oder S-förmige elastische und deshalb von den achsparallel wirkenden thermischen Beanspruchungen nicht mehr aufbrechbare elektromechanische Verbindung zwischen den Sacklöchern 12 und ihren Durchstiegen 24 geschaffen.

## Patentansprüche

1. Multilayer-Schaltungsaufbau (11) mit, insbesondere beidseitiger, SMD-Bestückung von Bauelementen (23) aufwenigstens einer der äußeren Oberflächen (22) eines verpreßten Stapels (14) von Leiterplatten (16), deren Kaschierungen (17) mittels Durchstiegen (24) miteinander verschaltet sind, **dadurch gekennzeichnet**,
daß zwischen der Montageoberfläche (22) für die Bauelemente (23) und den Leiterplatten (16) eine thermo-mechanische Entkopplungslage (20) vorgesehen ist, durch die hindurch die Montageoberfläche (22) mittels Sacklöchern (12) an Leiterplatten-Kaschierungen (17) angeschlossen ist, wobei die Sacklöcher (12) jeweils gegenüber an sie anzuschließenden Durchstiegen (24) axial versetzt sind und beide einen dazwischen sich erstreckenden Übergangsbereich (17s) der Leiterplatten-Kaschierung (17) in Bohrlöchern (27) kontaktierend durchgreifen.

2. Schaltungsaufbau nach Anspruch 1, **dadurch gekennzeichne**t,
daß die Sacklöcher (12) und die Durchstiege (24) an ihren Innenwandungen elektrisch leitende Galvanisierungen (30, 25) tragen.

3. Schaltungsaufbau nach Anspruch 1 oder 2, **dadurch gekennzeichnet**,
daß die Entkopplungslage (20) eine thermisch gut leitende und thermische Kräfte auch in Richtung quer zu ihrer Flächenausdehnung aufnehmende, gelochte Metallschichtplatte ist.

4. Schaltungsaufbau nach einem der vorangehenden Ansprüche, **dadurch gekennzeichnet**,
daß die Entkopplungslage (20) elektrisch isoliert mit leitenden Folien (21, 21') belegt ist, von denen die im Aufbau außen gelegene die Montageoberfläche (22) zur Aufnahme von Bauelementen (23) darstellt, während die innere als Verdrahtungs-Decklage (21') für den Stapel (14) von Leiterplatten (16) ausgelegt ist.
